# EUROPÄISCHE PATENTSCHRIFT

(11) **EP 2 747 085 B1**
(45) Veröffentlichungstag und Bekanntmachung des Hinweises auf die Patenterteilung: **12.04.2017**
(21) Anmeldenummer: 13005847.2
(22) Anmeldetag: 16.12.2013
(51) Int. Cl.: G11C 16/34

(54) **Verfahren zum Betreiben eines Sicherheitselements sowie ein solches Sicherheitselement**
Method for operating a safety element as well as such a safety element
Procédé de fonctionnement d'un élément de sécurité et élément de sécurité correspondant

(30) Priorität: 21.12.2012 DE 102012025261
(43) Veröffentlichungstag der Anmeldung: 25.06.2014
(73) Patentinhaber: Giesecke & Devrient GmbH, 81677 München (DE)
(72) Erfinder: Mathé, Werner, 82216 Maisach (DE)

(56) Entgegenhaltungen:
- DE-A1- 4 312 928

## Beschreibung

Die Erfindung betrifft ein Verfahren zum Betreiben eines Sicherheitselements (Secure Element) sowie ein solches Sicherheitselement. Als Sicherheitselemente werden hier insbesondere Teilnehmeridentifikationsmodule verstanden, wie eine eUICC/UICC (embedded universal integrated circuit card), eine SIM-Karte (subscriber identification module), ein M2M-Modul oder dergleichen.

Sicherheitselemente (Secure Elements) in Form von Teilnehmeridentifikationsmodulen dienen dazu, einen Teilnehmer gegenüber einem Mobilfunknetzwerk zu authentisieren. Hierzu ist ein solches Sicherheitselement in der Regel Teil eines mobilen Endgeräts, z.B. eines Mobiltelefons, und verfügt über eine zentrale Prozessoreinheit (CPU; central processing unit) zur Durchführung der Authentisierung und eine Speichereinheit zur sicheren Aufbewahrung von Teilnehmeridentifikationsdaten, beispielsweise eine IMSI (international mobile subscriber identity) und ein Authentisierungsschlüssel Ki, die für eine erfolgreiche Authentisierung erforderlich sind.

In der Vergangenheit war es bei Sicherheitselementen in Form von SIM-Karten in der Regel so, dass bei einem Wechsel des Besitzers eines Mobiltelefons von einem Mobilfunknetzbetreiber zu einem anderen Mobilfunknetzbetreiber die SIM-Karte des bisherigen Mobilfunknetzbetreibers mit der SIM-Karte des neuen Mobilfunknetzbetreibers im Mobiltelefon ausgetauscht werden musste, auf der insbesondere die Teilnehmeridentifikationsdaten hinterlegt sind, die für eine Authentisierung gegenüber dem neuen Mobilfunknetz erforderlich sind. Da in Zukunft jedoch immer mehr Sicherheitselemente fester Bestandteil eines mobilen Endgeräts sein werden, müssen in diesem Fall beim Wechsel zu einem neuen Mobilfunknetzbetreiber derartige Teilnehmeridentifikationsdaten in ein solches Sicherheitselement über die Luftschnittstelle (OTA; over-the-air) nachgeladen werden. In der Regel ist es dabei jedoch mit einem Nachladen von Teilnehmeridentifikationsdaten nicht getan, sondern es müssen oftmals ein neues Betriebssystem des Sicherheitselements und/oder Programmcode für neue Applikationen für das Sicherheitselement nachgeladen werden.

Herkömmlicherweise weist ein Sicherheitselement einen Flash-Speicher auf, um beispielsweise ein Betriebssystem, Programmcode für Applikationen und nicht-flüchtige Daten zu speichern. Da jedoch in der Regel der in einem mobilen Endgerät für ein Sicherheitselement zur Verfügung stehende Raum beschränkt ist, in dem dieses verbaut bzw. eingesteckt werden kann, ist auch die Fläche beschränkt, die dem Flash-Speicher auf einem Sicherheitselement zur Verfügung steht. Folglich weisen die in Sicherheitselementen verbauten Flash-Speicher auch aus Kostengründen in der Regel eine begrenzte Speicherkapazität in der Größenordnung von einigen hundert Kilobytes auf.

Bei Sicherheitselementen mit Speichereinheiten in Form von Flash-Speichern wird das Problem des zur Verfügung stehenden begrenzten Speicherplatzes noch dadurch verschärft, dass in der Regel bei einem Flash-Speicher mittels einer Flash-Translation-Layer (FTL) versucht wird, die Lebensdauer des Flash-Speichers zu maximieren. Der Grund hierfür liegt darin, dass eine Speicherzelle eines Flash-Speichers je nach Qualität maximal 100.000 Schreibvorgänge absolvieren kann. Mittels der FTL wird diesem Effekt entgegen gewirkt, indem die FTL Schreibvorgänge auf die Speicherzellen des Flash-Speichers so verteilt, dass jede Speicherzelle möglichst gleich häufig beschrieben wird, was dem Fachmann unter dem Begriff "Wear Leveling" bekannt ist. Dabei können durch das "Wear Leveling" einige Bereiche des Flash-Speichers, z.B. bereits sehr häufig beschriebene Speicherzellen, über bestimmte Zeiträume von der FTL im Wesentlichen vollständig blockiert werden, was zur Folge hat, dass die Größe des effektiv zur Verfügung stehenden logischen Speichers um einiges kleiner als die Größe des tatsächlichen physikalischen Speichers eines Flash-Speichers ist.

Da beim Herunterladen und beim Installieren insbesondere eines neuen Betriebssystems eines Sicherheitselements zumindest für eine Übergangsphase das bestehende Betriebssystem und das neue Betriebssystem nebeneinander auf einem Sicherheitselement existieren müssen, um zum einen das Herunterladen des neuen Betriebssystem durch das bestehende Betriebssystem zu koordinieren und zum anderen im Falle von Fehlern beim Laden des neuen Betriebssystems die Möglichkeit einer Rückkehr zum bestehenden Betriebssystems offen zu halten, kann das Problem auftreten, dass die von der FTL verwaltete Speichereinheit nicht genügend Speicher zur Verfügung stellen kann, um ein bestehendes Betriebssystem und ein neues nachgeladenes Betriebssystem gemeinsam auf der Speichereinheit zu speichern.

Aus der DE 43 12 928 ist ein "Wear Leveling"-Mechanismus für Informationsblöcke bekannt, bei dem ein Verwaltungsblock mit Daten beschrieben wird, die sich nur selten verändern.

Vor diesem Hintergrund stellt sich der vorliegenden Erfindung die Aufgabe, ein Verfahren zum Betreiben eines Sicherheitselements mit einer Prozessoreinheit und einer Speichereinheit vorzugsweise in Form eines Flash-Speichers, in dem ein "Wear Leveling"-Mechanismus implementiert ist, sowie ein solches Sicherheitselement bereitzustellen, die ein Nachladen von Programmcode insbesondere eines neuen Betriebssystems des Sicherheitselements erlauben.

Diese Aufgabe wird erfindungsgemäß durch das Verfahren zum Betreiben eines Sicherheitselements nach Anspruch 1 gelöst. Ein entsprechendes Sicherheitselement ist Gegenstand des unabhängigen Vorrichtungsanspruchs. Vorteilhafte Weiterbildungen der Erfindung sind in den Unteransprüchen definiert.

Gemäß einem ersten Aspekt der Erfindung wird ein Verfahren zum Betreiben eines Sicherheitselements zur sicheren Aufbewahrung von Daten und/ oder zur Identifikation eines Teilnehmers in einem mobilen Kommunikationsnetzwerk bereitgestellt, wobei das Sicherheitselement eine zentrale Prozessoreinheit und eine Speichereinheit mit einem nichtflüchtigen, wiederbeschreibbaren Speicher mit einer Vielzahl von Speicherzellen umfasst, in dem bestehender Programmcode für den Betrieb des Sicherheitselements hinterlegt ist und ein "Wear Leveling"-Mechanismus derart implementiert ist, dass zur Gleichverteilung der Schreibzugriffe der Prozessoreinheit auf die Speicherzellen des nichtflüchtigen Speichers die Prozessoreinheit in jedem gegebenen Zustand immer nur auf einen Teil der Vielzahl von Speicherzellen des nichtflüchtigen Speichers zugreifen kann, wobei das Verfahren den Schritt des Hinterlegens von neuem Programmcode für den Betrieb des Sicherheitselements in den Speicherzellen des nichtflüchtigen Speichers umfasst, auf die die Prozessoreinheit aufgrund des "Wear Leveling"-Mechanismus in einem gegebenen Zustand nicht zugreift.

Gemäß bevorzugter Ausführungsformen der Erfindung ist der "Wear Leveling"-Mechanismus mittels einer Flash-Translation-Layer (FTL) implementiert, bei der es sich bekanntermaßen um eine Software-Schicht über der eigentlichen Speicher-Hardware handelt, die neben dem "Wear Leveling" in der Regel dazu dient, als defekt erkannte Speicherzellen im nichtflüchtigen Speicher zu verwalten.

Vorzugsweise wird der neue Programmcode für den Betrieb des Sicherheitselements von einem Hintergrundsystem über ein Mobilfunknetzwerk heruntergeladen.

Gemäß bevorzugter Ausführungsformen der Erfindung handelt es sich bei dem nichtflüchtigen Speicher um einen EEPROM-Speicher, vorzugsweise um einen Flash-EEPORM-Speicher mit NOR-Architektur.

Vorzugsweise handelt es sich bei dem bestehenden Programmcode für den Betrieb des Sicherheitselements um ein bestehendes Betriebssystem für das Sicherheitselement und bei dem neuen Programmcode für den Betrieb des Sicherheitselements um ein neues Betriebssystem für das Sicherheitselement.

Gemäß bevorzugter Ausführungsformen der Erfindung wird das bestehende Betriebssystem im nichtflüchtigen Speicher vor Ort (execution in place) ausgeführt. Vorzugsweise ist das bestehende Betriebssystem als ein zusammenhängender Block im nichtflüchtigen Speicher hinterlegt, der bei einer Speicherzelle startet, auf die ein Boot-Loader verweist.

Vorzugsweise ist der Boot-Loader dazu ausgestaltet, bei einem Neustart des Sicherheitselements zu überprüfen, ob ein neues Betriebssystem in den von dem "Wear Leveling"-Mechanismus blockierten Speicherzellen vorliegt. Ist dies der Fall, beginnt der Boot-Loader mit der Installation des neuen Betriebssystems. Hierzu kann dem Boot-Loader eine Liste der Speicherzellen bereitgestellt werden, in denen das neue Betriebssystem abgelegt ist, und eine Liste der Speicherzellen oder alternativ der Beginn des Bereichs von Speicherzellen, in denen/ dem das neue Betriebssystem abgelegt werden soll. Andernfalls verweist der Boot-Loader die Prozessoreinheit auf die Speicherzelle des Speichers, bei der das bestehende Betriebssystem hinterlegt ist, um an dieser Stelle das bestehende Betriebssystem auszuführen.

Vorzugsweise sind das bestehende und das neue Betriebssystem in mehrere Bibliotheken, d.h. Gruppen von Funktionen, aufgeteilt.

Gemäß einem zweiten Aspekt der Erfindung wird ein Sicherheitselement zur sicheren Aufbewahrung von Daten und/oder zur Identifikation eines Teilnehmers in einem mobilen Kommunikationsnetzwerk bereitgestellt, wobei das Sicherheitselement eine zentrale Prozessoreinheit und eine Speichereinheit mit einem nichtflüchtigen, wiederbeschreibbaren Speicher mit einer Vielzahl von Speicherzellen umfasst, in dem bestehender Programmcode für den Betrieb des Sicherheitselements hinterlegt ist und ein "Wear Leveling"-Mechanismus derart implementiert ist, dass zur Gleichverteilung der Schreibzugriffe der Prozessoreinheit auf die Speicherzellen des nichtflüchtigen Speichers die Prozessoreinheit in jedem gegebenen Zustand immer nur auf einen Teil der Vielzahl von Speicherzellen des nichtflüchtigen Speichers zugreifen kann, wobei das Sicherheitselement dazu ausgestaltet ist, nach einem Verfahren gemäß dem ersten Aspekt der Erfindung betrieben zu werden.

Vorzugsweise handelt es sich bei dem Sicherheitselement um eine eUICC/UICC, eine SIM-Karte oder ein M2M-Modul.

Wie der Fachmann erkennt, lassen sich die vorstehend beschriebenen bevorzugten Ausgestaltungen sowohl im Rahmen des ersten Aspekts der Erfindung, d.h. im Rahmen des Verfahrens zum Betreiben eines Sicherheitselements, als auch im Rahmen des zweiten Aspekts der Erfindung, d.h. im Rahmen des Sicherheitselements, vorteilhaft implementieren.

Weitere Merkmale, Vorteile und Aufgaben der Erfindung gehen aus der folgenden detaillierten Beschreibung mehrerer Ausführungsbeispiele und Ausführungsalternativen hervor. Es wird auf die Zeichnungen verwiesen, in denen zeigen:
- Fig. 1: eine schematische Darstellung einer bevorzugten Ausführungsform eines erfindungsgemäßen Sicherheitselements in Form einer eUICC, das über ein Mobilfunknetzwerk in Kommunikation mit einem Hintergrundsystem steht, und
- Fig. 2: eine schematische Detaildarstellung der nichtflüchtigen Speichereinheit des Sicherheitselements von Figur 1 und der Arbeitsweise der darin implementierten Flash-Translation-Layer gemäß einer bevorzugten Ausführungsform der Erfindung.

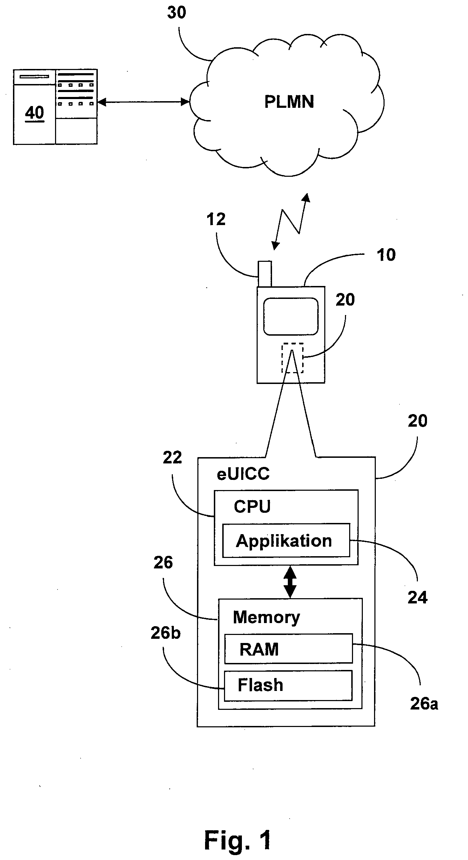

Figur 1 zeigt eine schematische Darstellung einer bevorzugten Ausführungsform eines erfindungsgemäßen Sicherheitselements 20, beispielsweise in Form einer eUICC/UICC (embedded universal integrated circuit card), einer SIM-Karte oder eines M2M-Moduls, das Teil eines mobilen Endgeräts 10 ist, bei dem es sich beispielsweise um ein Mobiltelefon handeln kann. Das mobile Endgerät 10 ist dazu ausgestaltet über ein Mobilfünknetzwerk oder PLMN (public land mobile network) 30 mit anderen mobilen Endgeräten und einem Hintergrundsystem 40 zu kommunizieren. Hierzu verfügt das mobile Endgerät 10 über eine geeignete Kommunikationsschnittstelle 12, die beispielsweise einen Transceiver umfassen kann.

Das Sicherheitselement 20 ist dazu ausgestaltet, mit dem mobilen Endgerät 10 Daten auszutauschen. Hierzu verfügt das mobile Endgerät 10 in der Regel über ein geeignetes Lesegerät, in welches das Sicherheitselement 20 derart eingesteckt ist, dass Kontaktflächen des Sicherheitselements 20 mit entsprechenden Kontaktflächen des Lesegeräts des mobilen Endgeräts 10 galvanisch in Kontakt sind. Alternativ kann das Sicherheitselement 20 auch fester Bestandteil des mobilen Endgeräts 10 sein. Es wird dann als eUICC bezeichnet.

Wie sich dies der Detaildarstellung des Sicherheitselements 20 in Figur 1 entnehmen lässt, umfasst das Sicherheitselement 20 in Form einer (e)UICC eine zentrale Prozessor- bzw. Recheneinheit (CPU; central processing unit) 22 und eine Speichereinheit (memory) 26, die einen flüchtigen Speicher (RAM; random access memory) 26a und einen nichtflüchtigen wieder beschreibbaren Speicher (NVM; non-volatile memory) 26b aufweist. Vorzugsweise handelt es sich bei dem nichtflüchtigen Speicher 26b um einen EEPROM-Speicher und weiter bevorzugt um einen Flash-Speicher.

Wie dies dem Fachmann bekannt ist, kann die Kommunikation zwischen der zentralen Prozessoreinheit 22 und der Speichereinheit 26 des Sicherheitselements 20 beispielsweise über ein oder mehrere Adress-, Daten- und/ oder Steuer-Bussysteme erfolgen, wie dies in Figur 1 schematisch durch einen Doppelpfeil angedeutet ist. Falls das Sicherheitselement 20 fester Bestandteil des mobilen Endgeräts 10 ist, kann auch die Kommunikation zwischen dem Sicherheitselement 20 und dem mobilen Endgerät 10 über ein oder mehrere derartige Bussysteme erfolgen.

Vorzugsweise ist die Prozessoreinheit 22 des Sicherheitselements 20 derart ausgestaltet, dass auf dieser wenigstens eine Applikation 24 ausgeführt werden kann, beispielsweise zum Auswählen, Herunterladen und Installieren eines neuen Betriebssystem für das Sicherheitselement, das beispielsweise Teil eines kompletten Subskriptionspakets sein könnte, welches ferner Subskriptionsdaten bzw. Teilnehmeridentifikationsdaten enthält.

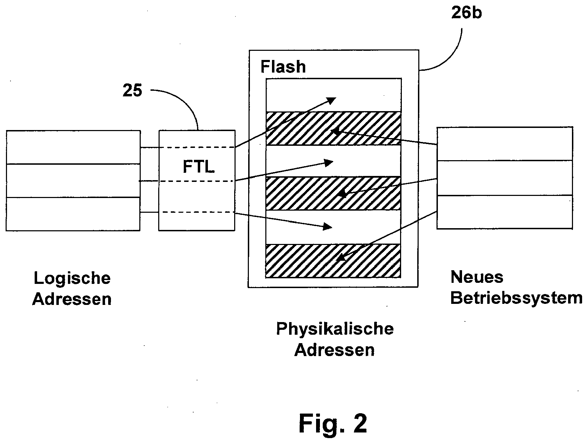

Figur 2 zeigt eine schematische Detaildarstellung des nichtflüchtigen Speichers 26b der Speichereinheit 26 des Sicherheitselements 20. Wie bereits vorstehend beschrieben, handelt es sich bei dem nichtflüchtigen wieder beschreibbaren Speicher 26b vorzugsweise um einen EEPROM-Speicher, noch weiter bevorzugt um einen Flash-Speicher mit einer Vielzahl von Speicherzellen. Erfindungsgemäß ist auf dem nichtflüchtigen Speicher 26b ein "Wear Leveling"-Mechanismus implementiert, der dazu ausgestaltet ist, die Schreibzugriffe der Prozessoreinheit 22 auf die Speicherzellen des nichtflüchtigen Speichers 26b so zu verteilen, dass jede Speicherzelle möglichst gleich häufig beschrieben wird. Im bevorzugten Fall eines nichtflüchtigen Speichers 26b in Form eines Flash-Speichers handelt es sich bei dem "Wear Leveling"-Mechanismus vorzugsweise um eine Flash-Translation-Layer (FTL). Dem Fachmann ist bekannt, dass es sich bei einer Flash-Translation-Layer (FTL) um eine Software-Schicht über der eigentlichen Speicher-Hardware handelt, die in der Regel neben der Implementierung eines "Wear Leveling"-Mechanismus dazu dient, als defekt erkannte Speicherzellen im nichtflüchtigen Speicher 26b zu verwalten.

Wie dies in Figur 2 schematisch dargestellt ist, stehen der Prozessoreinheit 22 im normalen Betrieb des Sicherheitselements 20 lediglich die von der Flash-Translation-Layer 25 verwalteten logischen Adressen zur Verfügung, die bestimmten physikalischen Adressen bzw. Speicherzellen des nichtflüchtigen Speichers 26b entsprechen. Ein Zugriff der Prozessoreinheit 22 auf die in Figur 2 schraffiert dargestellten beispielhaften physikalischen Adressen bzw. Speicherzellen wird nicht unterstützt, da aufgrund des in Form der Flash-Translation-Layer (FTL) implementierten "Wear Leveling"-Mechanismus keine logische Adressen auf diese physikalischen Adressen verweisen. Der Fachmann wird erkennen, dass aufgrund des mittels der FTL implementierten "Wear Leveling"-Mechanismus die Zuordnung von logischen Adressen zu physikalischen Adressen des nichtflüchtigen Speichers 26b durch die FTL nicht konstant, sondern sich mit wachsender Zahl von Zugriffen der Prozessoreinheit 22 auf die logischen Adressen ändern wird. Über eine bestimmte Anzahl von Zugriffen der Prozessoreinheit 22 auf die von der FTL verwalteten logischen Adressen wird die von der FTL durchgesetzte Zuordnung zwischen logischen Adressen und physikalischen Adressen bzw. Speicherzellen des nichtflüchtigen Speichers 26b jedoch in der Regel konstant sein. Bei den logischen Adressen bzw. den entsprechenden physikalischen Adressen bzw. Speicherzellen des nichtflüchtigen Speichers 26b, auf welche die Prozessoreinheit 22 zugreifen kann, ist vorzugsweise insbesondere ein bestehendes Betriebssystem für das Sicherheitselement 20 hinterlegt, und zwar vorzugsweise als zusammenhängender Block, der die Ausführung des bestehenden Betriebssystems im nichtflüchtigen Speicher 26b erlaubt, was dem Fachmann unter dem Begriff "execution in place" bekannt ist. Wie der Name dies andeutet, wird bei der "execution in place" der im nichtflüchtigen Speicher 26b abgelegte Programmcode nicht in den Arbeitsspeicher 26a geladen, sondern direkt im nichtflüchtigen Speicher 26b ausgeführt. Dies setzt in der Regel voraus, dass die Prozessoreinheit 22 den nichtflüchtigen Speicher 26b direkt adressieren und sich den Programmcode schnell genug von dort holen kann. Der adressierte nichtflüchtige Speicher 26b muss also eine ausreichend kurze Zugriffszeit aufweisen, was beispielsweise bei einem Flash-Speicher gegeben ist.

Erfindungsgemäß ist nun vorgesehen, dass ein neues vom Hintergrundsystem 40 bereitgestelltes und über das Mobilfunknetzwerk 30 heruntergeladenes Betriebssystem für das Sicherheitselement 20 gerade an den physikalischen Adressen bzw. Speicherzellen des nichtflüchtigen Speichers 26b gespeichert wird, auf die die Prozessoreinheit 22 im aktuellen Zustand aufgrund der FTL nicht zugreifen soll, wie dies in Figur 2 schematisch dargestellt ist. Mit anderen Worten, beim Ablegen eines nachgeladenen neuen Betriebssystems auf dem nichtflüchtigen Speicher 26b der Speichereinheit 26 wird kurzzeitig der mittels der FTL implementierte "Wear Leveling"-Mechanismus modifiziert, indem mehr physische Seiten Verwendung finden als dies von der FTL empfohlen bzw. vorgegeben wird. Das nachgeladene neue Betriebssystem wird gerade in den Speicherzellen des nichtflüchtigen Speichers 26b hinterlegt, die im momentanen Zustand des Sicherheitselements 20 durch Zugriffe der Prozessoreinheit 22 nicht weiter abgenutzt werden sollen.

Sobald gemäß dem vorstehend beschriebenen Verfahren das neue Betriebssystem im nichtflüchtigen Speicher 26b hinterlegt worden ist, wird das Sicherheitselement 20 vorzugsweise neu gestartet, beispielsweise mittels eines Reset-Vorgangs. Beim Neustart des Sicherheitselements 20 wird vorzugsweise zunächst ein Boot-Loader gestartet, der dazu ausgestaltet ist, bei einem Neustart des Sicherheitselements 20 zu überprüfen, ob ein neues Betriebssystem in den aufgrund des "Wear Leveling"-Mechanismus nicht unterstützten Speicherzellen des nichtflüchtigen Speichers 26b vorliegt. Falls der Boot-Loader kein neues Betriebssystem findet, startet die Prozessoreinheit 22 mit der Ausführung des Programmcodes des bestehenden Betriebssystems bei einer Speicherzelle bzw. Adresse des nichtflüchtigen Speichers 26b, auf die der Boot-Loader verweist. Wie vorstehend beschrieben, ist das bestehende Betriebssystem vorzugsweise als Block ab einer fest definierten Speicherzelle bzw. Adresse im nichtflüchtigen Speicher 26b hinterlegt, damit es dort an Ort und Stelle ausgeführt werden kann.

Andernfalls, d.h. falls der Boot-Loader ein neues Betriebssystem in den aufgrund des "Wear Level"-Mechanismus gerade nicht benutzten Speicherzellen des nichtflüchtigen Speichers 26b findet, beginnt der Boot-Loader mit der Installation des neuen Betriebssystems. Hierzu kann dem Boot-Loader eine Liste der Speicherzellen bereitgestellt werden, in denen das neue Betriebssystem abgelegt ist, und eine Liste der Speicherzellen, in denen das neue Betriebssystem abgelegt werden soll, oder alternativ die fest definierte Speicherzelle bzw. Startadresse, bei der das bestehende Betriebssystem als Block abgelegt ist und bei der das neue Betriebssystem abgelegt werden soll.

Erfindungsgemäß ist nun vorstellbar, dass das neue Betriebssystem in Teilen Schritt für Schritt mit entsprechenden Teilen des bestehenden Betriebssystems ausgetauscht wird. Dies erlaubt es, dass neue Betriebssystem als anwachsenden Block ab der fest definierten Speicherzelle bzw. Adresse in den nicht-flüchtigen Speicher 26b zu schreiben, bei der bisher das bestehenden Betriebssystem als Block hinterlegt gewesen ist. Im Gegenzug kann das bestehende Betriebssystem Schritt für Schritt in die Speicherzellen des nichtflüchtigen Speichers 26b verschoben werden, in denen bisher die entsprechenden Teile des neuen Betriebssystem hinterlegt gewesen sind, d.h. in die Speicherzellen, auf die die Prozessoreinheit 22 aufgrund der FTL im normalen Betrieb nicht zugreifen soll. Sobald der Boot-Loader auf diese Art und Weise erfolgreich alle entsprechenden Speicherzellen des nicht-flüchtigen Speichers 26b ausgetauscht hat, kann das Sicherheitselement 20 mit dem neuen Betriebssystem neu gestartet werden. Falls es beim Kopieren des neuen Betriebssystems zu einer Unterbrechung kommen sollte, kann dieser Vorgang wiederholt werden bis er vollständig ausgeführt wurde. Durch den Vorgang wird das alte Betriebssystem gelöscht. Mit anderen Worten, vorzugsweise erfolgt das Überschreiben des bestehenden Betriebssystems durch das neue Betriebssystem atomar.

Um die zu ersetzenden Teile des bestehenden Betriebssystems für das Sicherheitselement 20 möglichst klein zu halten, ist gemäß bevorzugter Ausführungsformen der Erfindung eine Aufteilung des bestehenden und des neuen Betriebssystems in Bibliotheken vorgesehen. Diese können bei ausreichend Platz im System auch ohne Neustart ersetzt werden. Dazu ist dann jeweils eine Indirektion beim Einsprung in die Bibliotheken erforderlich.

Obwohl bei der vorstehend beschriebenen bevorzugten Ausführungsform der Erfindung der "Wear Leveling"-Mechanismus mittels einer Flash-Translation-Layer (FTL), also im Wesentlichen in Software implementiert ist, umfasst die Erfindung ebenfalls Ausgestaltungen, bei denen der "Wear Leveling"-Mechanismus im Wesentlichen in Hardware implementiert ist. Beispielsweise kann hierzu eine Speicherverwaltungseinheit (Memory Management Unit) verwendet werden.

## Patentansprüche

1. Verfahren zum Betreiben eines Sicherheitselements (20) zur sicheren Aufbewahrung von Daten und/oder zur Identifikation eines Teilnehmers in einem mobilen Kommunikationsnetzwerk (30), wobei das Sicherheitselement (20) eine zentrale Prozessoreinheit (22) und eine Speichereinheit (26) mit einem nichtflüchtigen, wiederbeschreibbaren Speicher (26b) mit einer Vielzahl von Speicherzellen umfasst, in dem bestehender Programmcode für den Betrieb des Sicherheitselements hinterlegt ist und ein "Wear Leveling"-Mechanismus derart implementiert ist, dass zur Gleichverteilung der Schreibzugriffe der Prozessoreinheit (22) auf die Speicherzellen des nichtflüchtigen Speichers (26b) die Prozessoreinheit (22) in einem gegebenen Zustand immer nur auf einen Teil der Vielzahl von Speicherzellen des nichtflüchtigen Speichers (26b) zugreifen kann, wobei das Verfahren den Schritt des Hinterlegens von neuem Programmcode für den Betrieb des Sicherheitselements (20) in den Speicherzellen des nichtflüchtigen Speichers (26b) umfasst, auf die die Prozessoreinheit (22) aufgrund des "Wear Leveling"-Mechanismus in einem gegebenen Zustand nicht zugreifen soll.

2. Verfahren nach Anspruch 1, wobei der "Wear Leveling"-Mechanismus mittels einer Flash-Translation-Layer (FTL) implementiert ist.

3. Verfahren nach Anspruch 1, wobei der neue Programmcode für den Betrieb des Sicherheitselements (20) von einem Hintergrundsystem (40) über das Mobilfunknetzwerk (30) heruntergeladen wird.

4. Verfahren nach Anspruch 1, wobei es sich bei dem nichtflüchtigen Speicher (26b) um einen EEPROM-Speicher, vorzugsweise um einen Flash-EEPORM-Speicher mit NOR-Architektur.

5. Verfahren nach Anspruch 1, wobei es sich bei dem bestehenden Programmcode für den Betrieb des Sicherheitselements (20) um ein bestehendes Betriebssystem für das Sicherheitselement (20) und bei dem neuen Programmcode für den Betrieb des Sicherheitselements (20) um ein neues Betriebssystem für das Sicherheitselement (20) handelt.

6. Verfahren nach Anspruch 5, wobei das bestehende Betriebssystem im nichtflüchtigen Speicher (26b) vor Ort (execution in place) ausgeführt wird und als ein zusammenhängender Block im nichtflüchtigen Speicher (26b) hinterlegt ist, der bei einer Speicherzelle des nicht-flüchtigen Speichers (26b) beginnt, auf die ein Boot-Loader verweist.

7. Verfahren nach Anspruch 6, wobei der Boot-Loader dazu ausgestaltet ist, bei einem Neustart des Sicherheitselements (20) zu überprüfen, ob das neue Betriebssystem in den von dem "Wear Leveling"-Mechanismus blockierten Speicherzellen vorliegt, und, wenn dies der Fall ist, die Installation des neuen Betriebssystems anzustoßen.

8. Verfahren nach Anspruch 7, wobei dem Boot-Loader eine Liste der Speicherzellen des nicht-flüchtigen Speichers (26b) bereitgestellt wird, in denen das neue Betriebssystem abgelegt ist, und eine Liste der Speicherzellen des nicht-flüchtigen Speichers (26b), in denen das neue Betriebssystem abgelegt werden soll.

9. Sicherheitselement (20) zur sicheren Aufbewahrung von Daten und/oder zur Identifikation eines Teilnehmers in einem mobilen Kommunikationsnetzwerk (30), wobei das Sicherheitselement (20) eine zentrale Prozessoreinheit (22) und eine Speichereinheit (26) mit einem nichtflüchtigen, wiederbeschreibbaren Speicher (26b) mit einer Vielzahl von Speicherzellen umfasst, in dem bestehender Programmcode für den Betrieb des Sicherheitselements hinterlegt ist und ein "Wear Leveling"-Mechanismus derart implementiert ist, dass zur Gleichverteilung der Schreibzugriffe der Prozessoreinheit (22) auf die Speicherzellen des nichtflüchtigen Speichers (26b) die Prozessoreinheit (22) in einem gegebenen Zustand immer nur auf einen Teil der Vielzahl von Speicherzellen des nichtflüchtigen Speichers (26b) zugreifen kann, wobei das Sicherheitselement (20) dazu ausgestaltet ist, nach einem Verfahren gemäß einem der vorhergehenden Ansprüche betrieben zu werden.

10. Sicherheitselement (20) nach Anspruch 9, wobei es sich bei dem Sicherheitselement (20) um eine eUICC/UICC, eine SIM-Karte oder ein M2M-Modul handelt.

## Claims

1. A method for operating a security element (20) for securely storing data and/or for identifying a subscriber in a mobile communication network (30), wherein the security element (20) comprises a central processor unit (22) and a memory unit (26) with a nonvolatile, rewritable memory (26b) having a multiplicity of memory cells in which there is deposited existing program code for the operation of the security element and there is implemented "wear leveling" mechanism in such a fashion that for the equal distribution of the write accesses of the processor unit (22) to the memory cells of the non-volatile memory (26b), the processor unit (22) can, in a given state, always access only on a part of the multiplicity of memory cells of the nonvolatile memory (26b), wherein the method comprises the step of depositing new program code for the operation of the security element (20) in the memory cells of the nonvolatile memory (26b) which the processor unit (22) is not intended to access in a given state, due to the "wear leveling" mechanism.

2. The method according to claim 1, wherein the "wear leveling" mechanism is implemented by means of a flash translation layer (FTL).

3. The method according to claim 1, wherein the new program code for the operation of the security element (20) is downloaded from a background system (40) via the mobile communication network (30).

4. The method according to claim 1, wherein the nonvolatile memory (26b) is an EEPROM memory, preferably a flash EEPROM memory with NOR architecture.

5. The method according to claim 1, wherein the existing program code for the operation of the security element (20) is an existing operating system for the security element (20) and the new program code for the operation of the security element (20) is a new operating system for the security element (20).

6. The method according to claim 5, wherein the existing operating system is executed in place in the nonvolatile memory (26b) (execution in place) and is deposited as a contiguous block in the nonvolatile memory (26b), said block beginning at a memory cell of the non-volatile memory (26b) that is referenced by a boot loader.

7. The method according to claim 6, wherein the boot loader is configured to check, upon a reboot of the security element (20), whether the new operating system is present in the memory cells blocked by the "wear leveling" mechanism and, when this is the case, to initiate the installation of the new operating system.

8. The method according to claim 7, wherein the boot loader is provided with a list of the memory cells of the nonvolatile memory (26b) in which the new operating system is stored, and with a list of the memory cells of the nonvolatile memory (26b) in which the new operating system is to be stored.

9. A security element (20) for securely storing data and/or for identifying a subscriber in a mobile communication network (30), wherein the security element (20) comprises a central processor unit (22) and a memory unit (26) with a nonvolatile, rewritable memory (26b) having a multiplicity of memory cells in which there is deposited existing program code for the operation of the security element and there is implemented a "wear leveling" mechanism in such a fashion that for the equal distribution of the write accesses of the processor unit (22) to the memory cells of the nonvolatile memory (26b) the processor unit (22) can, in a given state, always access only on a part of the multiplicity of memory cells of the nonvolatile memory (26b), wherein the security element (20) is configured to be operated in accordance with a method according to any of the preceding claims.

10. The security element (20) according to claim 9, wherein the security element (20) is a eUICC/ UICC, a SIM card or an M2M module.

## Revendications

1. Procédé d'exploitation d'un élément de sécurité (20) destiné à la conservation sécurisée de données et/ou à l'identification d'un abonné dans un réseau mobile de communication (30), l'élément de sécurité (20) comprenant une unité centrale de processeur (22) et unité de mémoire (26) munie d'une mémoire (26b) réinscriptible non volatile qui a une pluralité de cellules mémoire et dans laquelle un code existant de programme pour l'exploitation de l'élément de sécurité est stocké et un mécanisme d'uniformation d'usure est mis en oeuvre de telle façon que, aux fins de la répartition uniforme des accès en écriture de l'unité de processeur (22) sur les cellules mémoire de la mémoire (26b) non volatile, l'unité de processeur (22) ne peut toujours, dans un état donné, accéder qu'à seulement une partie de la pluralité de cellules mémoire de la mémoire (26b) non volatile, le procédé comprenant l'étape du stockage de nouveau code de programme pour l'exploitation de l'élément de sécurité (20) dans les cellules mémoire de la mémoire (26b) non volatile auxquelles l'unité de processeur (22) ne doit pas, dans un état donné, accéder en raison du mécanisme d'uniformation d'usure.

2. Procédé selon la revendication 1, le mécanisme d'uniformation d'usure étant mis en oeuvre au moyen d'une couche de traduction flash (FTL).

3. Procédé selon la revendication 1, le nouveau code de programme pour l'exploitation de l'élément de sécurité (20) étant téléchargé par un système d'arrière-plan (40) par l'intermédiaire du réseau de radiocommunication mobile (30).

4. Procédé selon la revendication 1, la mémoire (26b) non volatile consistant en une mémoire EEPROM, de préférence en une mémoire flash EEPROM en architecture NOR.

5. Procédé selon la revendication 1, le code existant de programme pour l'exploitation de l'élément de sécurité (20) consistant en un système d'exploitation existant pour l'élément de sécurité (20), et le nouveau code de programme pour l'exploitation de l'élément de sécurité (20) consistant en un nouveau système d'exploitation pour l'élément de sécurité (20).

6. Procédé selon la revendication 5, le système d'exploitation existant étant exécuté sur place (execution in place) dans la mémoire (26b) non volatile et étant stocké dans la mémoire (26b) non volatile sous forme de bloc d'un seul tenant qui commence à une cellule mémoire de la mémoire (26b) non volatile à laquelle un chargeur d'amorçage renvoie.

7. Procédé selon la revendication 6, le chargeur d'amorçage étant configuré pour, lors d'un redémarrage de l'élément de sécurité (20), vérifier si le nouveau système d'exploitation se trouve dans les cellules mémoire bloquées par le mécanisme d'uniformation d'usure et, quand cela est le cas, pour lancer l'installation du nouveau système d'exploitation.

8. Procédé selon la revendication 7, il étant mis à disposition du chargeur d'amorçage une liste des cellules mémoire de la mémoire (26b) non volatile dans lesquelles le nouveau système d'exploitation est déposé, et une liste des cellules mémoire de la mémoire (26b) non volatile dans lesquelles le nouveau système d'exploitation doit être déposé.

9. Élément de sécurité (20) destiné à la conservation sécurisée de données et/ ou à l'identification d'un abonné dans un réseau mobile de communication (30), l'élément de sécurité (20) comprenant une unité centrale de processeur (22) et unité de mémoire (26) munie d'une mémoire (26b) réinscriptible non volatile qui a une pluralité de cellules mémoire et dans laquelle un code existant de programme pour l'exploitation de l'élément de sécurité est stocké et un un mécanisme d'uniformation d'usure est mis en oeuvre de telle façon que, aux fins de la répartition uniforme des accès en écriture de l'unité de processeur (22) sur les cellules mémoire de la mémoire (26b) non volatile, l'unité de processeur (22) ne peut toujours, dans un état donné, accéder qu'à seulement une partie de la pluralité de cellules mémoire de la mémoire (26b) non volatile, l'élément de sécurité (20) étant conçu pour être exploité selon un procédé d'une des revendications précédentes.

10. Élément de sécurité (20) selon la revendication 9, l'élément de sécurité (20) consistant en une eUICC/UICC, en une carte SIM ou en un module M2M.
